# FASCICULE DE BREVET EUROPEEN

(11) **EP 3 020 533 B1**
(45) Date de publication et mention de la délivrance du brevet: **28.08.2019**
(21) Numéro de dépôt: 15193542.6
(22) Date de dépôt: 06.11.2015
(51) Int. Cl.: B29C 65/08, B29C 65/60, B29C 65/78, G01R 22/06, H05K 5/02, B29C 65/58, B29L 31/34

(54) **ENSEMBLE COMPRENANT UN BOÎTIER ET UN CAPOT, ET PROCÉDÉ DE FIXATION DU CAPOT SUR LE BOÎTIER**
ANORDNUNG AUS EINEM GEHÄUSE UND EINER ABDECKUNG, UND VERFAHREN ZUR BEFESTIGUNG DER ABDECKUNG AUF DEM GEHÄUSE
ASSEMBLY COMPRISING A HOUSING AND A COVER, AND METHOD FOR ATTACHING THE COVER TO THE HOUSING

(30) Priorité: 13.11.2014 FR 1460969
(43) Date de publication de la demande: 18.05.2016
(73) Titulaire: SAGEMCOM ENERGY & TELECOM SAS, 92500 Rueil-Malmaison (FR)
(72) Inventeur: ROLLAND, Patrick, 92500 Rueil Malmaison (FR); BRETON, Thierry, 92500 Rueil Malmaison (FR)
(74) Mandataire: Lavialle, Bruno François Stéphane

(56) Documents cités:
- FR-A1- 2 997 261
- JP-A- 2000 127 248
- JP-A- 2000 299 568

## Description

L'invention concerne les appareils (compteur électrique, compteur de gaz, etc.) comprenant un boîtier, un capot pour refermer le boîtier, et dans lesquels une liaison mécanique par bouterollage contribue à effectuer un scellement du capot au boîtier. On rappellera que le bouterollage s'apparente au rivetage à chaud et consiste à fixer deux pièces l'une à l'autre en déformant à chaud l'extrémité libre d'un pion qui est solidaire d'une des pièces et qui traverse l'autre pièce (l'apport de chaleur pouvant être obtenu par chauffage ou friction).

### ARRIERE PLAN DE L'INVENTION

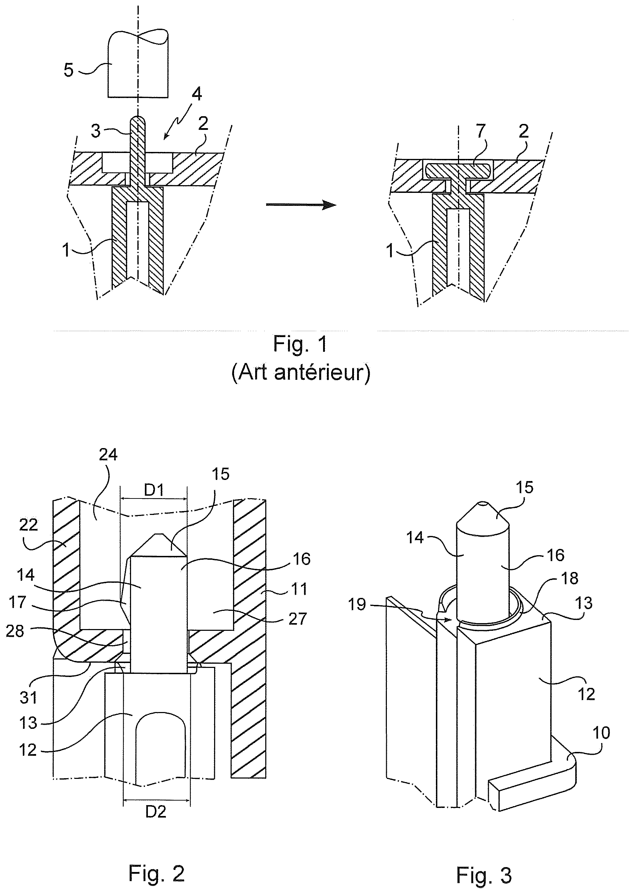

En référence à la figure 1, certains appareils comportent un ensemble comprenant un boîtier 1, un capot 2, ainsi que des moyens de fixation du capot 2 sur le boîtier 1 comprenant une liaison mécanique par bouterollage entre le boîtier 1 et le capot 2.

Pour réaliser cette liaison mécanique, on munit classiquement le boîtier 1 d'un pion de bouterollage 3 qui, lorsque le capot 2 ferme le boîtier 1, s'étend au travers d'un passage 4 pratiqué dans le capot 2. Le bouterollage consiste alors à utiliser un outil 5 pour faire fondre la partie du pion de bouterollage 3 qui dépasse du capot 2 et à former avec la partie fondue du pion de bouterollage 3 une tête bouterollée 7 qui s'oppose à la séparation du capot 2 et du boîtier 1 mais cela ne constitue pas un assemblage dit « complet ». La fusion de la partie du pion de bouterollage 3 (ou plus précisément son ramollissement) est réalisée par exemple en utilisant la technique du soudage par ultrasons, l'outil 5 est alors par exemple une sonotrode d'un pistolet de soudage.

Dans le cas d'un compteur électrique ou d'un compteur de gaz, la tête bouterollée 7, ou plutôt l'absence de tête bouterollée 7, est utilisée comme preuve visuelle d'une tentative d'ouverture du boîtier 1 du compteur et donc d'une tentative de fraude.

Pour rendre la fraude plus difficile, il est connu de positionner la tête bouterollée 7 au fond d'un puits relativement profond du capot 2 pour rendre la découpe de la tête bouterollée plus difficile. Il est malgré tout possible pour un fraudeur de détruire la tête bouterollée 7 de manière à pouvoir ouvrir le boîtier 1 en retirant le capot 2. Le fraudeur peut alors effectuer une opération frauduleuse puis refermer le capot 2 et reconstituer la tête bouterollée 7 au fond du puits, de sorte que la tentative de fraude n'est pas visible.

Il est également connu du document JP 2000127248 un ensemble comprenant un boîtier et un capot destiné à fermer le boîtier. Le boîtier comporte une base et un pion de bouterollage en saillie de la base, le capot comprend dans son épaisseur un passage traversant comportant un tronçon large débouchant sur une surface extérieure du capot et un tronçon étroit débouchant sur une surface intérieure du capot. Le boîtier et le capot étant agencés de sorte que, lorsque le capot ferme le boîtier, la surface intérieure du capot repose sur la base du boîtier et le pion de bouterollage s'étend dans le tronçon étroit et dans le tronçon large du passage traversant pour être fondu lors d'une opération de bouterollage de sorte qu'une partie fondue du pion de bouterollage s'étende dans le tronçon large en solidarisant le boîtier et le capot. La base du boîtier comporte un guide d'énergie s'étendant à proximité du pion de bouterollage pour être en contact de la surface intérieure du capot et fondre lors de l'opération de bouterollage de manière à solidariser la base du boîtier et la surface intérieure du capot.

### OBJET DE L'INVENTION

L'invention a pour objet d'améliorer la sécurité d'un ensemble comprenant un boîtier et un capot en empêchant d'effectuer une tentative de fraude pouvant être dissimulée.

### RESUME DE L'INVENTION

En vue de la réalisation de ce but, on propose un ensemble comprenant un boîtier et un capot destiné à fermer le boîtier, le boîtier comportant une base et un pion de bouterollage en saillie de la base, le capot comprenant dans son épaisseur un passage traversant comportant un tronçon large débouchant sur une surface extérieure du capot et un tronçon étroit débouchant sur une surface intérieure du capot, le boîtier et le capot étant agencés de sorte que, lorsque le capot ferme le boîtier, la surface intérieure du capot repose sur la base du boîtier et le pion de bouterollage s'étend dans le tronçon étroit et dans le tronçon large du passage traversant pour être fondu lors d'une opération de bouterollage de sorte qu'une partie fondue du pion de bouterollage s'étende dans le tronçon large en solidarisant le boîtier et le capot. La base du boîtier comporte un guide d'énergie s'étendant à proximité du pion de bouterollage pour être en contact de la surface intérieure du capot et fondre lors de l'opération de bouterollage de manière à solidariser la base du boîtier et la surface intérieure du capot. Le pion de bouterollage comprend une portion élargie présentant un diamètre supérieur au diamètre du tronçon étroit du passage traversant et le guide d'énergie s'étendant autour du pion de bouterollage à l'exception d'une portion angulaire.

Par guide d'énergie, on entend une forme permettant de concentrer l'échauffement dans une zone restreinte à l'interface entre la base du boîtier et le capot pour favoriser une fusion localisée du guide d'énergie et de la surface intérieure du capot au contact du guide d'énergie et obtenir une soudure de ceux-ci.

L'ensemble boîtier et capot de l'invention est alors plus économique à réaliser que les éléments de l'art antérieur. En effet, la fabrication du pion de bouterollage et du guide d'énergie peut être réalisée par moulage plutôt que par usinage. L'invention permet de pré-assembler le boîtier et le capot de manière à protéger le contenu du boîtier sans qu'il soit nécessaire de réaliser les opérations de bouterollage en flux tendu avec les opérations d'équipement des boîtiers. Ceci permet de limiter le nombre de machines et le nombre d'opérateurs requis pour la fabrication de l'ensemble boîtier/capot, résultant en une fabrication plus économique.

Lors de l'assemblage, le boîtier et le capot sont solidarisés en partie grâce à la déformation de la partie du pion de bouterollage qui s'étend dans le tronçon large, la partie déformée ne pouvant plus passer par le tronçon étroit, mais surtout grâce à la fusion du guide d'énergie sur la surface intérieure du capot. La fusion du guide d'énergie solidarise la base du boîtier et la surface intérieure du capot et constitue ainsi une liaison mécanique majeure de type soudure, inaccessible à un fraudeur. La tentative de fraude est donc non seulement très compliquée à réaliser mais aussi particulièrement difficile à dissimuler, puisqu'elle ne peut être effectuée sans détruire de manière visible une partie du boîtier et du capot.

On propose aussi un procédé de fixation d'un capot sur un boîtier d'un ensemble selon l'une des revendications précédentes, le procédé comprenant les étapes :
- de monter le capot sur le boîtier en insérant le pion de bouterollage dans le passage traversant au travers du tronçon étroit de manière à positionner la surface intérieure du capot sur la base du boîtier ;
- de réaliser une opération de bouterollage pour faire fondre à la fois une partie du pion de bouterollage qui s'étend dans le tronçon large du passage traversant et le guide d'énergie.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- la figure 1 représente une liaison mécanique par bouterollage d'un ensemble comprenant un boîtier et un capot de l'art antérieur ;
- la figure 2 représente une vue en coupe d'un pion de bouterollage du boîtier et d'un bloc colonne du capot de l'ensemble de l'invention ;
- la figure 3 représente une vue en perspective et de dessus du pion de bouterollage et d'une colonnette sur laquelle est montée le pion de bouterollage ;
- la figure 4 représente une vue en perspective et de derrière du pion de bouterollage et de la colonnette ;
- la figure 5 représente une vue en perspective et de devant du pion de bouterollage et de la colonnette ;
- la figure 6 représente une vue en perspective et de dessous du capot, du bloc colonne du capot et de la colonnette.

### DESCRIPTION DETAILLEE DE L'INVENTION

En référence aux figures 2 à 5, l'invention est ici appliquée à un compteur électrique comprenant un boîtier 10 et un capot 11 destiné à fermer le boîtier 10, le boîtier 10 et le capot 11 formant l'ensemble de l'invention.

Le boîtier 10 comporte une colonnette 12 qui s'étend depuis un fond du boîtier 10. La colonnette 12 comporte une surface supérieure formant une base 13 en saillie de laquelle s'étend un pion de bouterollage 14 qui, comme le reste du boîtier 10, est fabriqué en un matériau thermoplastique.

Le pion de bouterollage 14 comporte une tête conique 15 et une partie courante cylindrique 16. La partie courante cylindrique 16 du pion de bouterollage 14 comporte une portion élargie 17.

Un guide d'énergie 18 s'étend sur la base 13 à proximité du pion de bouterollage 14. Le guide d'énergie 18 est une nervure, de section triangulaire, qui s'étend en saillie de la base 13 au moins partiellement autour du pion de bouterollage 14. Ici, la nervure suit un contour circulaire quasi-complet, à l'exception d'une portion angulaire 19 correspondant à une partie évidée 20. La partie évidée 20 permet, au cours de la fabrication du boîtier 10, d'extraire d'un moule le pion de bouterollage 14 et plus particulièrement la portion élargie 17 de celui-ci.

Le capot 11, quant à lui, comporte un bloc colonne creux 22 qui s'étend depuis une face intérieure 23 du capot 11. Un puits 24 est constitué à l'intérieur du bloc colonne 22 et a un fond destiné à reposer sur le guide d'énergie 18. Le fonds du puits 24 est percé d'un orifice étroit de sorte que le puits et son fond délimitent un passage comportant un tronçon large 27 et un tronçon étroit 28.

Le tronçon large 27 débouche sur une surface extérieure 30 du capot 11, qui est en l'occurrence une face extérieure du capot 11. Le tronçon étroit 28 débouche sur une surface intérieure 31 du capot 11, ladite surface intérieure 31 s'étendant ici au niveau d'une extrémité libre du bloc colonne 22.

Le pion de bouterollage 14 du boîtier 10 et le bloc colonne 22 du capot 11 sont agencés de sorte que, lorsque le capot 11 ferme le boîtier 10, la surface intérieure 31 du capot 11 repose sur la base 13 de la colonnette 12 du boîtier 10. La partie courante 16 du pion de bouterollage 14 s'étend alors dans le tronçon étroit 28 et dans le tronçon large 27 au fond du puits 24.

Lorsqu'il convient de fermer le boîtier 10 de manière définitive, on met en oeuvre le procédé de fixation d'un capot sur un boîtier de l'invention.

Le procédé de l'invention consiste tout d'abord à monter le capot 11 sur le boîtier 10 en insérant le pion de bouterollage 14 dans le passage traversant au travers du tronçon étroit 28 de manière à positionner la surface intérieure 31 du capot 11 sur la base 13 du boîtier 10.

Puis, le procédé comprend une opération de bouterollage qui consiste à faire fondre à l'aide d'une sonotrode d'un pistolet de soudage (ou d'un autre outil si une technique différente de soudage est utilisée) la partie courante 16 du pion de bouterollage 14 qui s'étend dans le tronçon large 27. En se ramollissant, la partie du pion de bouterollage 14 qui s'étend dans le tronçon large 27 forme une tête de bouterollage de diamètre supérieur au diamètre du tronçon étroit 27 pour déborder latéralement sur le fond du puits 24 de manière à solidariser le capot 11 et le boîtier 10 en s'opposant à l'extraction du pion de bouterollage 14 hors du puits 24.

On note que, comme le puits 24 est relativement profond, il est difficile pour un fraudeur d'atteindre la tête bouterollée (mais pas impossible, comme cela a été dit plus tôt).

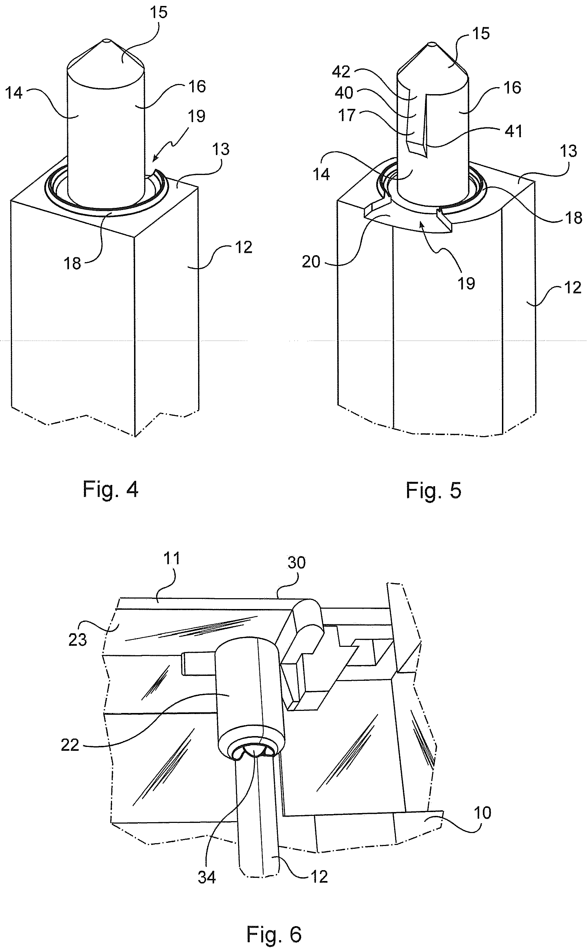

Lors de l'opération de bouterollage, le guide d'énergie 18 concentre grâce à sa forme une partie importante de l'énergie générée par les vibrations de haute fréquence transmises au pion de bouterollage 14 et à la base 13 de la colonnette 12 par la sonotrode. Cette concentration d'énergie fait fondre le guide d'énergie 18 et la partie du capot 11 en contact avec le guide d'énergie 18, ce qui soude la base 13 de la colonnette 12 du boîtier 10 et la surface intérieure 31 du capot 11. La partie fondue 34 résultant du soudage est visible sur la figure 6.

Ainsi, deux liaisons mécaniques solidarisent le boîtier 10 et le capot 11 via la tête bouterollée et la partie fondue 34. Si le fraudeur, muni par exemple d'un cutter, parvient à retirer la tête bouterollée malgré la profondeur du puits 24, la soudure empêche de retirer le capot 11 et donc d'ouvrir le boîtier 10 du compteur électrique.

On décrit désormais la structure et le rôle de la portion élargie 17 du pion de bouterollage 14 évoquée plus tôt, en référence à la figure 5.

La portion élargie 17 présente une rampe 40 positionnée le long de la partie courante 16 du pion de bouterollage 14. La rampe 40 s'étend entre une zone haute 41 située en regard de la base 13 de la colonnette 12 et une zone basse 42 située à proximité de la tête conique 15 du pion de bouterollage 14. Par « haute » et « basse », on fait référence à la hauteur de la rampe 40 par rapport à la surface de la partie courante 16 : ainsi, la rampe 40 est plus éloignée de l'axe de la partie courante 16 au niveau de la zone haute 41 et plus proche de l'axe de la partie courante 16 au niveau de la zone basse 42. La portion élargie 17 du pion de bouterollage 14 présente au niveau de la zone haute 41 un diamètre D1 supérieur au diamètre D2 du tronçon étroit 28 (D1 et D2 sont visibles sur la figure 2).

Lorsque le capot 11 est positionné sur le boîtier 10 pour le fermer, le pion de bouterollage 14 est inséré dans le tronçon étroit 28 en subissant une déformation élastique. La rampe 40 de la portion élargie 17 est destinée à faciliter l'insertion du pion de bouterollage 14 au travers du tronçon étroit 28.

La portion élargie 17 du pion de bouterollage 14 et le fond du puits 24 forment ainsi des moyens de maintien destinés à maintenir le capot 11 sur le boîtier 10 avant l'opération de bouterollage. Ces moyens de maintien sont particulièrement utiles pour transporter ou stocker le boîtier 10 et le capot 11 avant leur assemblage final.

Bien entendu, l'invention n'est pas limitée au mode de réalisation décrit mais englobe toute variante entrant dans le champ de l'invention telle que définie par les revendications.

En particulier, l'invention est applicable à tout type d'appareil comprenant un boîtier et un capot : compteur de gaz, équipement de mesure quelconque, etc.

Chaque pièce ou élément décrit ici pourrait avoir une structure ou une forme différente, à condition bien sûr d'être adapté à la mise en oeuvre de l'invention. Ainsi, le pion pourrait ne pas présenter une tête conique, le guide d'énergie pourrait ne pas entourer le pion ou bien l'entourer entièrement, il pourrait y avoir plusieurs guides d'énergie, le passage pourrait être formé, comme c'est le cas sur la figure 1, dans une partie plane principale du capot entre la face supérieure et la face inférieure du capot (la surface intérieure du capot coïnciderait alors avec la face intérieure du capot), etc.

## Revendications

1. Ensemble comprenant un boîtier (10) et un capot (11) destiné à fermer le boîtier (10), le boîtier comportant une base (13) et un pion de bouterollage (14) en saillie de la base, le capot comprenant dans son épaisseur un passage traversant comportant un tronçon large (27) débouchant sur une surface extérieure (30) du capot (11) et un tronçon étroit (28) débouchant sur une surface intérieure (31) du capot (11), le boîtier (10) et le capot (11) étant agencés de sorte que, lorsque le capot (11) ferme le boîtier (10), la surface intérieure du capot repose sur la base du boîtier et le pion de bouterollage (14) s'étend dans le tronçon étroit et dans le tronçon large du passage traversant pour être fondu lors d'une opération de bouterollage de sorte qu'une partie fondue du pion de bouterollage (14) s'étende dans le tronçon large en solidarisant le boîtier et le capot, la base du boîtier comportant un guide d'énergie (18) s'étendant à proximité du pion de bouterollage (14) pour être en contact de la surface intérieure du capot et fondre lors de l'opération de bouterollage de manière à solidariser la base du boîtier et la surface intérieure du capot, **caractérisé en ce que** le pion de bouterollage (14) comprend une portion élargie (17) présentant un diamètre (D1) supérieur au diamètre (D2) du tronçon étroit (28) du passage traversant et que le guide d'énergie (18) s'étend autour du pion de bouterollage (14) à l'exception d'une portion angulaire (19).

2. Ensemble selon la revendication 1, dans lequel le guide d'énergie (18) est une nervure pratiquée sur la base (13) du boîtier.

3. Ensemble selon l'une des revendications précédentes comportant en outre des moyens de maintien destinés à maintenir le capot (11) sur le boîtier (10) avant l'opération de bouterollage.

4. Ensemble selon la revendication 1, dans lequel la portion élargie (17) du pion de bouterollage (14) comporte une rampe (40) destinée à faciliter une insertion du pion de bouterollage au travers du tronçon étroit.

5. Procédé de fixation d'un capot sur un boîtier d'un ensemble selon l'une des revendications précédentes, le procédé comprenant les étapes :
- de monter le capot (11) sur le boîtier (10) en insérant le pion de bouterollage (14) dans le passage traversant au travers du tronçon étroit (28) de manière à positionner la surface intérieure (31) du capot (11) sur la base (13) du boîtier (10) ;
- de réaliser une opération de bouterollage pour faire fondre à la fois une partie du pion de bouterollage (14) qui s'étend dans le tronçon large (27) du passage traversant et le guide d'énergie (18).

## Patentansprüche

1. Anordnung, umfassend ein Gehäuse (10) und eine Abdeckung (11), die dazu bestimmt ist, das Gehäuse (10) zu verschließen, wobei das Gehäuse eine Basis (13) und einen von der Basis abstehenden Nietstift (14) umfasst, wobei die Abdeckung in ihrer Dicke einen Durchgang umfasst, der einen breiten Abschnitt (27) enthält, der auf einer Außenfläche (30) der Abdeckung (11) mündet, sowie einen engen Abschnitt (28), der auf einer Innenfläche (31) der Abdeckung (10) mündet, wobei das Gehäuse (10) und die Abdeckung (11) derart ausgebildet sind, dass, wenn die Abdeckung (11) das Gehäuse (10) verschließt, die Innenfläche der Abdeckung auf der Basis des Gehäuses ruht und sich der Nietstift (14) in dem engen Abschnitt und in dem breiten Abschnitt des Durchgangs erstreckt, um während eines Nietkopfformungsvorgangs derart geschmolzen zu werden, dass sich ein geschmolzener Teil des Nietstiftes (14) in dem breiten Abschnitt erstreckt und dabei das Gehäuse und die Abdeckung verbindet, wobei die Basis des Gehäuses eine Energieführung (18) umfasst, die sich nahe dem Nietstift (14) erstreckt, um mit der Innenfläche der Abdeckung in Kontakt zu stehen und während des Nietkopfformungsvorgangs derart zu schmelzen, dass die Basis des Gehäuses und die Innenfläche der Abdeckung verbunden werden, **dadurch gekennzeichnet, dass** der Nietstift (14) einen verbreiterten Abschnitt (17) hat, der einen Durchmesser (D1) aufweist, der größer als der Durchmesser (D2) des engen Abschnittes (28) des Durchgangs ist, und dass sich die Energieführung (18) mit Ausnahme eines Winkelabschnittes (19) um den Nietstift (14) herum erstreckt.

2. Anordnung nach Anspruch 1, bei der die Energieführung (18) eine Rippe ist, die auf der Basis (13) des Gehäuses ausgebildet ist.

3. Anordnung nach einem der vorhergehenden Ansprüche, ferner umfassend Haltemittel, die dazu bestimmt sind, die Abdeckung (11) auf dem Gehäuse (10) vor dem Nietkopfformungsvorgang zu halten.

4. Anordnung nach Anspruch 1, bei dem der verbreiterte Abschnitt (17) des Nietstiftes (14) eine Rampe (40) umfasst, die dazu bestimmt ist, ein Einfügen des Nietstiftes durch den engen Abschnitt zu erleichtern.

5. Verfahren zum Befestigen einer Abdeckung auf einem Gehäuse einer Anordnung nach einem der vorhergehenden Ansprüche, wobei das Verfahren die Schritte umfasst:
- Anbringen der Abdeckung (11) auf dem Gehäuse (10), indem der Nietstift (14) durch den engen Abschnitt (28) in den Durchgang derart eingefügt wird, dass die Innenfläche (31) der Abdeckung (11) auf der Basis (13) des Gehäuses (10) positioniert wird;
- Durchführen eines Nietkopfformungsvorgangs, um gleichzeitig einen Teil des Nietstiftes (14), der sich in dem breiten Abschnitt (27) des Durchgangs erstreckt, und die Energieführung (18) zu schmelzen.

## Claims

1. An assembly comprising a box (10) and a lid (11) for closing the box (10), the box having a base (13) and a staking stud (14) projecting from the base, the lid including in its thickness a through passage having a broad segment (27) opening out into an outside surface (30) of the lid (11), and a narrow segment (28) opening out into an inside surface (31) of the lid (11), the box (10) and the lid (11) being arranged in such a manner that, when the lid (11) closes the box (10), the inside surface of the lid rests on the base of the box and the staking stud (14) extends through the narrow segment and into the broad segment of the through passage in order to be melted during a staking operation so that a melted portion of the staking stud (14) extends in the broad segment and secures the box and the lid together, the base of the box including an energy guide (18) extending in the proximity of the staking stud (14) in order to be in contact with the inside surface of the lid and in order to melt during the staking operation so as to secure the base of the box together with the inside surface of the lid, the staking stud (14) having an enlargement (17) presenting a diameter (D1) greater than the diameter (D2) of the narrow segment (28) of the through passage, and in that the energy guide (18) extends around the staking stud (14) with the exception of an angular fraction (19).

2. An assembly according to claim 1, wherein the energy guide (18) is a rib formed on the base (13) of the box.

3. An assembly according to either preceding claim, further including holder means for holding the lid (11) on the box (10) prior to the staking operation.

4. An assembly according to claim 1, wherein the enlargement (17) of the staking stud (14) includes a ramp (40) for facilitating insertion of the staking stud through the narrow segment.

5. A method of fastening a lid on a box of an assembly according to any preceding claim, the method comprising the following steps:
- mounting the lid (11) on the box (10) by inserting the staking stud (14) into the through passage via the narrow segment (28) so as to position the inside surface (31) of the lid (11) on the base (13) of the box (10); and
- performing a staking operation in order to melt both a portion of the staking stud (14) that extends inside the broad segment (27) of the through passage, and also the energy guide (18).
